**Europäisches Patentamt**

(19) **European Patent Office**

**Office européen des brevets**

(11) Veröffentlichungsnummer: **0 060 324**
**A2**

(12) # EUROPÄISCHE PATENTANMELDUNG

(21) Anmeldenummer: **81108727.9**

(22) Anmeldetag: **22.10.81**

(51) Int. Cl.³: **H 03 K 5/153**, H 02 M 1/08

(30) Priorität: **13.03.81 DE 3109729**

(43) Veröffentlichungstag der Anmeldung: **22.09.82**
**Patentblatt 82/38**

(84) Benannte Vertragsstaaten: **AT BE CH FR GB IT LI NL**

(71) Anmelder: **SIEMENS AKTIENGESELLSCHAFT Berlin und München, Postfach 22 02 61, D-8000 München 22 (DE)**

(72) Erfinder: **Nicolaus, Robert, Peter-Dörfler-Strasse 3, D-8035 Gauting 2 Stockdorf (DE)**

(54) **Schaltungsanordnung zur Erzeugung eines digitalen Signals, welches vorgegebene Amplitudenwerte, insbesondere die Nulldurchgänge (Polaritätswechsel), einer alternierenden Spannung kennzeichnet.**

(57) In den Zeitpunkten der Nulldurchgänge (Polaritätswechsel) einer alternierenden Spannung (z.B. einer sinusförmigen Wechselspannung) sollen Schaltvorgänge (z.B. die Umschaltung eines Polwenders) ausgeführt werden. Zu diesem Zweck wird die alternierende Spannung in einer Gleichrichterschaltung, die wenigstens einen Proportionalverstärker (V1) und einen an dessen Ausgang angeschlossenes stromrichtungsabhängiges Schwellwertelement (Gleichrichterdiode G) enthält, einer Doppelweggleichrichtung unterworfen. An dem Verbindungspunkt zwischen dem Ausgang des Proportionalverstärkers und dem Schwellwertelement (G) ist wenigstens ein Komparator (K1) mit einem ersten Eingang angeschlossen. An den zweiten Eingang des Komparators (K1) ist eine Referenzspannung angelegt, deren Größe zumindest annähernd dem halben Wert der Schwellenspannung (us) des Schwellwertelementes (G) entspricht. Bei jedem Nulldurchgang der alternierenden Spannung (uE) durchläuft das Ausgangssignal des Proportionalverstärkers (V1) einen durch die Schwellenspannung (us) des Schwellwertelementes (G) gegebenen Spannungsbereich, in welchem der Gegenkopplungszweig des Proportionalverstärkers (V1) infolge des hohen differentiellen Widerstandes des Schwellwertelementes (G) nicht wirk-

sam ist, so dass die Änderungsgeschwindigkeit der Ausgangsspannung (uA) in diesem Spannungsbereich der Änderungsgeschwindigkeit der Eingangsspannung (uE) multipliziert mit der Leerlaufverstärkung des Proportionalverstärkers (V1) entspricht und dementsprechend sehr hoch ist. Dadurch wird der Komparator (K1) sehr genau im Zeitpunkt der Nulldurchgänge umgesteuert und liefert an seinem Ausgang (P1) das gewünschte digitale Schaltsignal.

0060324

SIEMENS AKTIENGESELLSCHAFT       Unser Zeichen
Berlin und München               VPA 81 P 6217 E

Schaltungsanordnung zur Erzeugung eines digitalen Signals, welches vorgegebene Amplitudenwerte, insbesondere die Nulldurchgänge (Polaritätswechsel), einer alternierenden Spannung kennzeichnet

Die Erfindung betrifft eine Schaltungsanordnung der im Gattungsbegriff des Patentanspruches 1 beschriebenen Art.

Ein bevorzugtes Anwendungsgebiet für derartige Schaltungsanordnungen sind z.B. Wechselrichter, bei denen ein mit vergleichsweise hoher Frequenz schwingender als Sperrwandler oder als Ein- oder Gegentaktdurchflußwandler ausgebildeter Umrichter mit einer doppelweggleichgerichteten (kommutierten) Referenzspannung moduliert wird und dessen Ausgangsspannung, deren zeitlicher Verlauf dem des kommutierten Referenzsignals entspricht, in einer gesteuerten Brückenschaltung (Polwenderbrücke) periodisch umgepolt und somit in die gewünschte alternierende Spannung umgewandelt wird. Der Hauptzweck der genannten Modulation mit dem kommutierten Referenzsignal und der anschließenden periodischen Umpolung ist die bessere Ausnutzung des in dem Umrichter vorgesehenen Transformators.

Die erwähnte periodische Umpolung stellt die Umkehrung der Doppelweggleichrichtung des Referenzsignals zur Gewinnung des Modulationssignals dar. Sie muß daher genau in den Zeitpunkten der Nulldurchgänge des ursprünglichen Referenzsignals erfolgen.

Der Erfindung liegt die Aufgabe zugrunde, eine Schaltungsanordnung der im Gattungsbegriff des Patentanspruches 1

Wf 1 Gru / 05.03.1981

beschriebenen Art möglichst einfach und damit kostensparend auszubilden.

Diese Aufgabe wird durch eine Schaltungsanordnung mit den Merkmalen des Patentanspruches 1 gelöst.

Die Erfindung geht also von der Erkenntnis aus, daß der in der Gleichrichterschaltung vorhandene vorzugsweise als gegengekoppelter Operationsverstärker ausgebildete Proportionalverstärker in einem durch die Schwellenspannung des Schwellwertelementes gegebenen Bereich seiner Ausgangsspannung auf einen sehr hohen differentiellen Widerstand arbeitet, so daß dieser Spannungsbereich sehr rasch durchlaufen wird, bis das Element niederohmig leitend wird. Die Änderungsgeschwindigkeit dieses Spannungsanstieges ist praktisch um den vollen Leerlaufverstärkungsfaktor des Verstärkers größer als die Änderungsgeschwindigkeit der Eingangsspannung, wenn die durch innere Speicherzeiten und Kapazitäten gegebenen Begrenzungen vernachlässigt werden. Daher eignet sich die in Rede stehende Spannungsänderung zur zeitgenauen Umsteuerung eines Komparators, an dessen Ausgang das gewünschte digitale Signal abgreifbar ist, wenn die Bezugsspannung des Komparators innerhalb des und vorzugsweise etwa in der Mitte des erwähnten Spannungsbereiches liegt.

Wenn das Referenzsignal seine Nullinie in entgegengesetzter Richtung durchläuft, wird das stromrichtungsabhängige Schwellwertelement nach Erreichen seiner Schwellenspannung wieder hochohmig, so daß wieder eine entsprechend rasche Änderung der Ausgangsspannung des Verstärkers gegeben ist, durch die der Komparator in Gegenrichtung umgesteuert wird.

Vorteilhafte Weiterbildungen und Ausgestaltungen der Erfindung sind Gegenstand der Unteransprüche, auf die hiermit zur Verkürzung der Beschreibung ausdrücklich verwie-

sen wird.

Im folgenden sei die Erfindung anhand der Zeichnung näher erläutert:

Fig. 1 zeigt ein Ausführungsbeispiel der Schaltungsanordnung gemäß der Erfindung,
Fig. 2 zeigt zwei Spannungsverläufe zur Veranschaulichung
der Wirkungsweise der Schaltung gemäß Fig. 1.

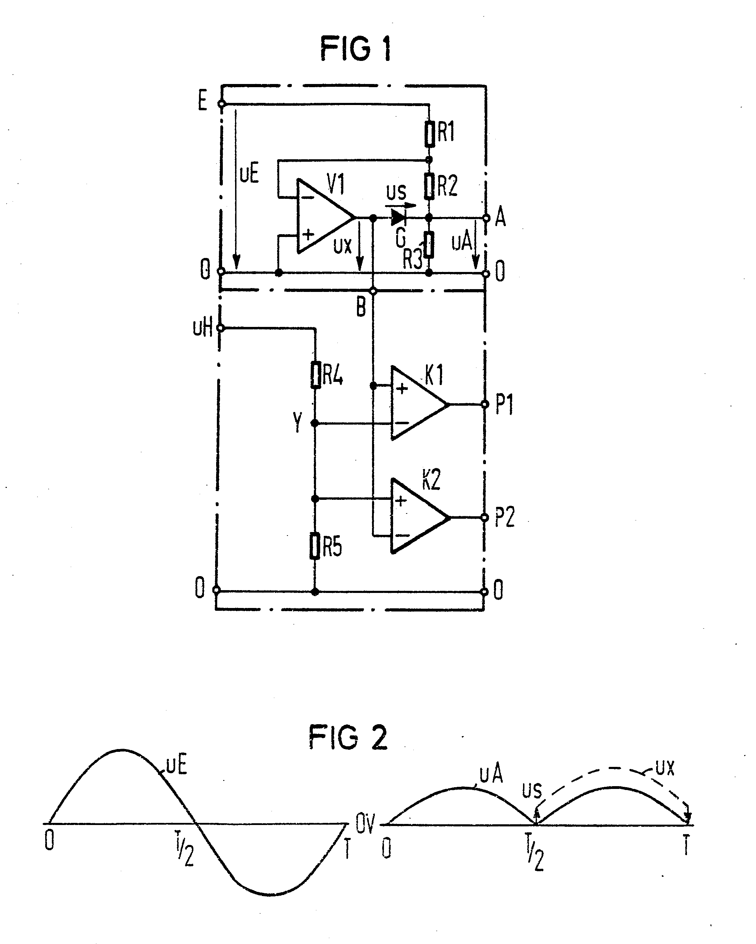

Die in Fig. 1 dargestellte Schaltung umfaßt einen Gleichrichterteil 1 sowie eine Komparatorschaltung 2. Der
Gleichrichterteil besteht aus einem Operationsverstärker
V1, Widerständen R1, R2 und R3 und einer Gleichrichterdiode G. Der Widerstand R1 verbindet den mit E bezeichneten Eingang des Gleichrichterteils mit dem invertierenden
Eingang des Operationsverstärkers V1. Der Widerstand R2
bildet einen Gegenkopplungszweig und verbindet den Ausgang
A des Gleichrichterteils 1 mit dem invertierenden Eingang
des Operationsverstärkers V1. Der Widerstand R3 schließlich liegt zwischen der mit A bezeichneten Ausgangsklemme
und der mit dem Bezugspotential verbundenen Ausgangsklemme O. Die Gleichrichterdiode G ist zwischen den mit B bezeichneten Ausgang des Operationsverstärkers V1 und den
Ausgang A eingefügt. Die Spannung an dem Ausgang B des
Operationsverstärkers V1 ist mit ux bezeichnet.

Der Ausgang B des Operationsverstärkers V1 ist mit dem
nichtinvertierenden Eingang des Komparators K1 und dem
invertierenden Eingang des Komparators K2 verbunden. Der
invertierende Eingang des Komparators K1 und der nichtinvertierende Eingang des Komparators K2 sind gemeinsam
mit einem Schaltungspunkt Y verbunden, an dem eine Vergleichsspannung auftritt, die durch einen aus Widerständen R4 und R5 bestehenden Spannungsteiler aus einer mit
UH bezeichneten Hilfsspannung gewonnen wird.

Im folgenden sei die Wirkungsweise der Schaltung erläutert:

Zunächst sei der Gleichrichterteil 1 betrachtet. An seinen Eingangsklemmen E und O liegt die mit uE bezeichnete sinusförmige Wechselspannung einer nicht dargestellten Signalquelle an. Der zeitliche Verlauf dieser Eingangsspannung uE ist in Fig. 2 links dargestellt. Der rechte Teil von Fig. 2 zeigt die Spannung uA am Ausgang A des Gleichrichterteils 1. Die positiven Halbwellen der Eingangsspannung uE gelangen über den aus den Widerständen R1, R2 und R3 bestehenden Spannungsteiler direkt zum Ausgang A. Sie hat dort den Wert

$$uApos = uE \cdot \frac{R3}{R1+R2+R3}.$$

Falls der Operationsverstärker V1 mit Zweispannungsversorgung betrieben wird, erscheint an seinem Ausgang während der positiven Halbwelle der Eingangsspannung uE eine negative Spannung, die durch die für die entsprechende Stromrichtung gesperrte Gleichrichterdiode G vom Ausgang A ferngehalten wird.

Während der negativen Halbwellen der Spannung uE ist der Operationsverstärker V1 wirksam und verstärkt das an seinem invertierenden Eingang anliegende Signal mit dem durch die äußere Beschaltung gegebenen Verstärkungsfaktor. Die Ausgangsspannung an der Klemme A hat daher während der negativen Halbwellen von uE den Wert

$$uAneg = - uE \cdot \frac{R2}{R1}.$$

Da die Spannung uAneg das entgegengesetzte Vorzeichen der (negativen) Eingangsspannung uE hat, wird die negative Halbwelle von uE in der aus Fig. 2 rechts ersichtlichen Weise umgepolt. Die beiden aufeinanderfolgenden Halbwellen der Ausgangsspannung uA haben die gleiche Amplitude

wenn die Bedingung

$$\frac{R2}{R1} = \frac{R3}{R1+R2+R3}$$

erfüllt ist.

Die Spannung ux am Ausgang B des Operationsverstärkers V1 ist während der negativen Halbwellen von uE um den Spannungsabfall an der Gleichrichterdiode G größer als die Spannung uA am Ausgang A. Dieser Spannungsabfall ist die mit us bezeichnete Schwellenspannung der Gleichrichterdiode und beträgt beispielsweise bei Siliziumdioden etwa 0,5 V. Der Verlauf der Spannung ux am Ausgang B des Operationsverstärkers V1 ist in Fig. 2 rechts mit gestrichelter Linie angedeutet.

Solange die Spannung ux am Ausgang B des Operationsverstärkers V1 nach dem Nulldurchgang der Eingangsspannung uE von einer positiven zu einer negativen Halbwelle noch kleiner ist als diese Schwellenspannung us, besitzt die Gleichrichterdiode G einen sehr hohen differentiellen Widerstand, so daß die Gegenkopplung über den Widerstand R2 noch nicht wirksam ist. Daher ist die Änderungsgeschwindigkeit der Spannung ux in diesem Spannungsbereich (unter Vernachlässigung der inneren Kapazitäten und Speicherzeiten) um den (sehr hohen) Grundverstärkungsfaktor des Operationsverstärkers V1 größer als die Änderungsgeschwindigkeit der Eingangsspannung uE beim Nulldurchgang. Da dieser Spannungsbereich infolgedessen außerordentlich schnell durchlaufen wird, eignet sich die entsprechende Spannungsänderung als Schaltkriterium zur Markierung des Nulldurchganges der Eingangsspannung uE.

Die Spannung ux am Ausgang B des Operationsverstärkers V1 wird dem nichtinvertierenden Eingang des Komparators K1 zugeführt, dessen invertierender Eingang auf einer Bezugsspannung liegt, die etwa dem halben Wert der Schwellenspannung us der Gleichrichterdiode G entspricht und die durch den Spannungsteiler R4/R5 aus der Hilfsspannung UH gewonnen wird. Sobald die Spannung ux den Wert dieser Bezugsspannung überschreitet - und das ist aus den oben erwähnten Gründen praktisch genau im Zeitpunkt des Nulldurchganges der Eingangsspannung uE der Fall -ändert sich der Signalpegel am Ausgang P1 des Komparators K1.

Die Spannung ux wird ferner dem invertierenden Eingang des Komparators K2 zugeführt, dessen nichtinvertierender Eingang ebenfalls auf der genannten Bezugsspannung liegt, so daß am Ausgang P2 im gleichen Zeitpunkt eine entgegengesetzt gerichtete Pegeländerung auftritt.

Wenn die Eingangsspannung uE nach dem Ende einer negativen Halbwelle wieder ihr Vorzeichen ändert, wird der zwischen dem Wert der Schwellenspannung us der Gleichrichterdiode G und dem Wert Null liegende Spannungsbereich der Ausgangsspannung ux des Operationsverstärkers V1 ebenfalls wieder sehr rasch durchlaufen, so daß die beiden Komparatoren K1 und K2 ihren Schaltzustand wieder praktisch genau beim Nulldurchgang der Eingangsspannung uE ändern. Infolgedessen tritt zwischen denAusgängen P1 und P2 der Komparatoren K1 und K2 eine Rechteckspannung auf. Falls Impulse nur einer Phasenlage benötigt werden, kann - je nachdem, welche Phasenlage benötigt wird - einer der beiden Komparatoren K1 oder K2 entfallen.

3 Patentansprüche
2 Figuren

0060324

Patentansprüche

1. Schaltungsanordnung zur Erzeugung eines digitalen Signals, welches vorgegebene Amplitudenwerte, insbesondere die Nulldurchgänge (Polaritätswechsel), einer alternierenden Spannung, z.B. einer sinusförmigen Wechselspannung, kennzeichnet, wobei die alternierende Spannung von einem Signalgenerator erzeugt und in einer wenigstens einen Proportionalverstärker und ein diesem nachgeschaltetes stromrichtungsabhängiges Schwellwertelement enthaltenden Gleichrichterschaltung doppelweggleichgerichtet (kommutiert) wird, d a d u r c h   g e k e n n z e i c h n e t , daß wenigstens ein Komparator (K1, K2) vorgesehen ist, der mit einem seiner Eingänge an das genannte Schwellwertelement (G) angeschlossen ist und an dessen anderem Eingang eine Referenzspannung anliegt, deren Größe zumindest annähernd dem halben Wert der Schwellenspannung (us) des Schwellwertelementes (G) entspricht, derart daß der Komparator (z.B. K1) durch denjenigen Teil der Ausgangsspannung (ux) des Proportionalverstärkers (V1) umschaltbar ist, welcher einem differentiell hochohmigen Abschnitt der Strom-Spannungskennlinie des Schwellwertelementes (G) entspricht.

2. Schaltungsanordnung nach Anspruch 1, bei der die Gleichrichterschaltung einen Operationsverstärker enthält, dessen invertierender Eingang über einen Eingangswiderstand mit dem Signalgenerator und über einen Gegenkopplungswiderstand mit dem Ausgang der Gleichrichterschaltung verbunden ist und dessen Ausgang über einen für die invertierten Halbwellen der alternierenden Spannung in Durchlaßrichtung gepolten Gleichrichter ebenfalls mit dem Ausgang der Gleichrichterschaltung verbunden ist, derart daß Halbwellen einer Polarität über den Eingangs- und den Gegenkopplungswiderstand unmittelbar zum Ausgang und Halbwellen der entgegengesetzten Polarität über den Operationsverstärker und den Gleichrichter zum Ausgang der

Gleichrichterschaltung gelangen, d a d u r c h  g e -
k e n n z e i c h n e t , daß der Verbindungspunkt (B)
zwischen dem Ausgang des Operationsverstärkers (V1) und
dem Gleichrichter (G) an den Steuereingang des Komparators
/z.B. K1) angeschlossen ist, an dessen anderem Eingang
eine zumindest annähernd der halben Schwellenspannung
(us) des Gleichrichters (G) entsprechende Referenzspannung anliegt, derart daß der Signalpegel am Ausgang (P1)
des Komparators (K1) wechselt, wenn die Ausgangsspannung
(ux) des Operationsverstärkers (V1) den zwischen der Spannung Null und der Schwellenspannung (us) des Gleichrichters (G) liegenden Spannungsbereich durchläuft.

3. Schaltungsanordnung nach Anspruch 2, d a d u r c h
g e k e n n z e i c h n e t , daß ein weiterer Komparator
(K2) vorgesehen ist, dessen Eingänge derart mit den Eingängen des erstgenannten Komparators (K1) verbunden sind,
daß er im Gegentakt zu diesem steuerbar ist.

1/1

## FIG 1

## FIG 2